# EUROPEAN PATENT SPECIFICATION

(11) **EP 1 659 646 B1**
(45) Date of publication and mention of the grant of the patent: **13.01.2010**
(21) Application number: 05110595.5
(22) Date of filing: 10.11.2005
(51) Int. Cl.: H01L 51/52

(54) **Sealant pattern for flat display panel**
Strukturierte Verkapselung für einen Flachbildschirm
Scellement structuré pour écran plat

(30) Priority: 22.11.2004 KR 2004095942
(43) Date of publication of application: 24.05.2006
(60) Divisional application: 09170922.0
(73) Proprietor: Samsung Mobile Display Co., Ltd., Suwon-si Gyeonggi-do (KR)
(72) Inventor: Lee, Sun-Youl, Legal & IP Team, Giheung-eup, Yongin-si, Gyeonggi-do (KR)
(74) Representative: Hengelhaupt, Jürgen

(56) References cited:
- WO-A-03/077608
- JP-A- 2001 155 855
- US-A1- 2002 074 931
- US-A1- 2003 178 923
- US-A1- 2004 171 184
- US-B1- 6 791 660

## Description

### BACKGROUND OF THE INVENTION

### Field of the Invention

The present invention relates to a flat display panel, and more particularly, to a sealant having protrusion parts on corners of a substrate and an Organic Light Emitting Diode (OLED) using the sealant.

### Description of the Related Art

Light emitting diodes are classified into inorganic Light Emitting Diodes (LEDs) and Organic Light Emitting Diodes (OLEDs) according to the kind of light emitting compound used to form an organic film layer between an anode electrode and a cathode electrode. Inorganic LEDs have a long lifetime, but have low light emission efficiency and a high driving voltage. On the other hand, OLEDs have high light emitting efficiency and a low driving voltage, but have a short lifetime.

An OLED includes anode electrodes arranged in one direction, cathode electrodes arranged to cross the anode electrodes, and organic light emitting layers interposed between the anode electrodes and the cathode electrodes on a substrate. An OLED is an emissive device, that is, it includes an organic light emitting layer that emits light according to the voltages supplied to the anode electrode and the cathode electrode.

OLEDs are widely used since they have a high resolution and a high impact resistance, and can realize a full color image. However, after a prolonged period of driving, OLEDs not only suffer from severe degradation of light emission characteristics, such as brightness and uniformity of light, but also have a short lifespan.

One of the causes of the degradation of the light emission characteristics and the short lifespan is the separation of the organic film layer from the electrodes due to moisture absorbed by the organic film layer and penetrating into the OLED through a defective portion or an edge of the OLED. The separation of the organic film layer from the electrodes produces dark points which do not emit light.

In the prior art, to prevent the degradation of the characteristics and the reduction of lifespan of an OLED by moisture and air, a substrate on which the OLED is formed, that is, an array substrate, is sealed by a sealing member using a sealant. However, in the case of an OLED in which the substrate is sealed by the sealing member using the sealant, the characteristics are degraded or the lifespan is reduced due to the moisture and oxygen penetrating from the outside or already absorbed in the organic film layer.

In the prior art, to maintain the characteristics and to extend the lifespan of an OLED by preventing defects such as dark points caused by the penetration of moisture and air, a protection film is formed on the entire surface of the substrate on which the OLED is formed or a substrate on which the OLED is sealed by a sealing substrate that includes a moisture absorbing material using a sealant.

Japanese Laid -Open Patent No. 2002-184569 relates to an organic light emitting display device having a sealing structure for preventing the penetration of oxygen and moisture by forming a metal absorption film on the OLED after a substrate, on which the OLED has been formed, is sealed by a sealing substrate using a sealant.

Japanese Laid -Open Patent No. 2002-280169 relates to an organic light emitting display device having an OLED within an inner barrier rib of a frame-type and having an outer barrier rib of a frame-type formed along the inner barrier rib of a frame-type. The reliability of the organic light emitting display device is improved by reducing the penetration of moisture by bonding an upper substrate and a lower substrate using an adhesive filled between the inner barrier rib of a frame-type and the outer barrier rib of a frame-type.
Figure 1C of US 2003/0178923 shows a sealant according to the preamble of claim 1.

However, in the above-noted organic light emitting display device, the sealant pattern for sealing upper and lower substrates has a frame-type. Therefore, the upper and lower substrates can be easily exfoliated by impacts on the corners of the substrates, thereby reducing the reliability and lifespan of the device. Particularly, in a flexible organic light emitting display device, the separation is severe at the edge portions of the panel due to bending of the substrate.

### SUMMARY OF THE INVENTION

The present invention is defined in claim 1.

A flat display device is provided including: a substrate including an image display unit on which display devices are arranged; and a sealing member adapted to seal the substrate with a sealant, the sealant including a frame portion adapted to surround the image display unit and protrusion portions protruding from the frame portion at the corners of the substrate.

The frame portion of the sealant includes frame members. The frame portion of the sealant preferably includes angled or rounded corners.

The protrusion parts of the sealant include four block pattern shaped parts protruding from the frame portion at the corners of the substrate. The protruded pattern shaped part consist of a rectangular shape.

The flat display device further includes an organic light emitting display device.

The sealant is selected from the group consisting of a thermosetting resin, an ultraviolet setting resin, and a thermoplastic resin.

The flat display device preferably further includes a flexible display device including a flexible substrate as the substrate and the sealing member.

### BRIEF DESCRIPTION OF THE DRAWINGS

A more complete appreciation of the present invention, and many of the attendant advantages thereof, will be readily apparent as the present invention becomes better understood by reference to the following detailed description when considered in conjunction with the accompanying drawings in which like reference symbols indicate the same or similar components, wherein:

FIG. 1 is a plan view of an organic light emitting display device useful for understanding the present invention;

FIG. 2 is a cross-sectional view taken along line II-II of FIG. 1; and

FIG. 3 is a plan view of an organic light emitting display device according to the present invention.

### DETAILED DESCRIPTION OF THE INVENTION

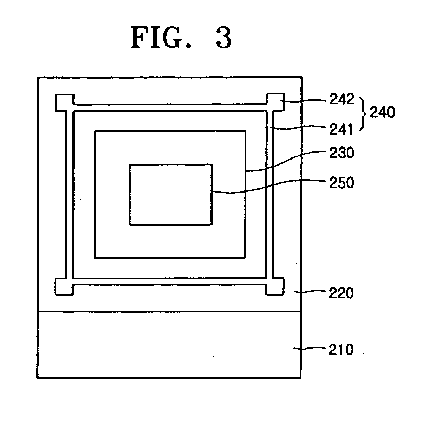

The present invention is described more fully below with reference to Fig. 3 in which the invention is shown.

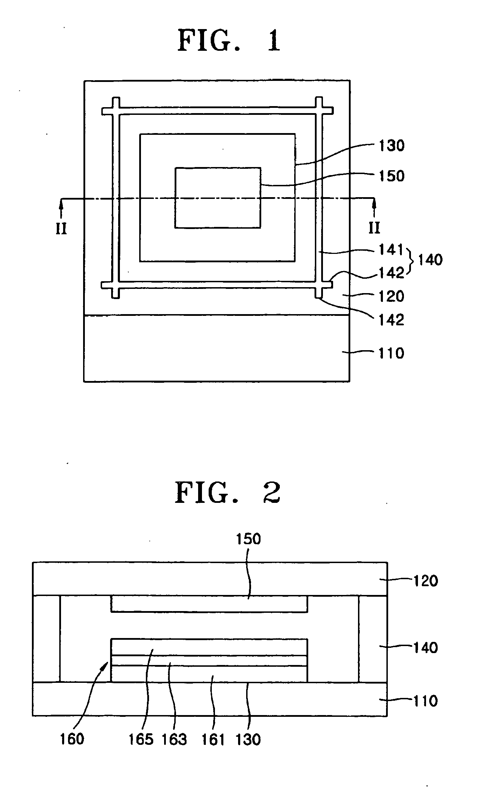

FIG. 1 is a plan view of an organic light emitting display device useful for understanding the present invention.

Referring to FIG. 1, an organic light emitting display device includes a substrate 110 having an image display unit 130. Organic Light Emitting Diodes (OLEDs) are arranged on the image display unit 130 of the substrate 110. The substrate 110 can be a glass substrate or a flexible substrate. The organic light emitting display device includes a flexible display device that uses a flexible substrate as the substrate 110.

The flexible substrate can be formed of a polymer plastic film, and is preferably formed of a film having high heat resistance to withstand the temperatures used in manufacturing the display device. The flexible substrate can be formed of polyethersulphone (PES), polyacrylate (PAR), polyetherimide (PEI), polyethylene napthalate (PEN), polyethylene terephthalate (PET).

The OLEDs arranged on the substrate 110 are sealed by a sealing member 120. The sealing member 120 includes a glass substrate, a metal cap, or a synthetic resin film. Also, the sealing member 120 can include a flexible substrate like the substrate 110.

The sealing member 120 includes an absorbent 150 for absorbing moisture or oxygen contained in the air between the substrate 110 and the sealing member 120. The absorbent 150 can include silica, synthetic zeolite, P₂O₅, or BaO, or can include an absorbent that hardens by heat or ultraviolet rays.

The substrate 110 and the sealing member 120 are bonded by a sealant 140. The sealant 140 includes a frame portion 141 having a frame shape that surrounds the image display unit 130 along the edges of the substrate 110 or the sealing member 120 and protrusion portions 142 having a bar shape protruding from the corners of the frame portion 141. The frame portion 141 can have an angled corner frame shape or a rounded corner frame shape. The size of the protrusion portions 142 is determined by the size of a region on which the sealant 140 is coated and is a few hundred micrometers.

The sealant 140 can include a thermosetting resin, an ultraviolet ray setting resin, and a thermoplastic resin. The thermosetting sealant can include resins of phenols, epoxies, polyurethanes, and polyesters.

The frame portion 141 of the sealant 140 has a frame shape surrounding the image display unit 130 along the edges of the substrate 110 or the sealing member 120. That is, the frame portion 141 of the sealant 140 can be arranged in any form along the edges of the substrate 110 or the sealing member 120.

Also, the protrusion portions 142 include two bar patterns protruding from the corners of the frame portion 141 and the protrusion portions 142 have the same width of the frame portion 141. The protrusion portions 142 can include at least one bar pattern protruding from the corners of the frame portion 141, and the width of the bar pattern can vary independently of the width of the frame portion 141.

FIG. 2 is a cross-sectional view taken along line II-II of FIG. 1. Referring to FIG. 2, OLEDs 160 are arranged in the image display unit 130 of the substrate 110. The OLEDs 160 includes a lower electrode 161, an organic thin film layer 163, and an upper electrode 165. The organic thin film layer 163 includes at least one organic film selected from among a hole injection layer, a hole transport layer, a light emitting layer, an electron transport layer, an electron injection layer, and a hole blocking layer. The lower electrode 161 and the upper electrode 165 include a transparent electrode or an non-transparent electrode according to the direction of light emitted from the light emitting layer.

If the organic light emitting display device is an active matrix type, a thin film transistor (not shown) for driving the organic light emitting diode can also be included.

The organic light emitting display device is not limited to the structure of the organic light emitting display device depicted in FIG. 2.

FIG. 3 is a plan view of an organic light emitting display device according to the present invention.

Referring to FIG. 3, an organic light emitting display device according to the present invention includes a substrate 210 having an image display unit 230 and a sealing member 220 for sealing the image display unit 230 of the substrate 210. As depicted in FIG. 2, OLEDs are arranged in the image display unit 230 of the substrate 210.

The substrate 210 can be a glass substrate or a flexible substrate. The flexible substrate can be formed of polyethersulphone (PES), polyacrylate (PAR), polyetherimide (PEI), polyethylene napthalate (PEN), polyethylene terephthalate (PET).

The sealing member 220 can be a glass substrate, a metal cap, or a synthetic resin film. The sealing member 220 includes an absorbent 250 for absorbing moisture or oxygen contained in the air between the substrate 210 and the sealing member 220. The absorbent 250 can include silica, synthetic zeolite, P₂O₅, or BaO, or can include an absorbent that hardens by heat or ultraviolet rays.

The substrate 210 and the sealing member 220 are bonded by a sealant 240. The sealant 240 includes a frame portion 241 having a frame shape that surrounds the image display unit 230 along the edges of the substrate 210 or the sealing member 220 and protrusion portions 242 having a block shape protruding from the corners of the frame portion 241. The frame portion 241 can have an angled corner frame shape or a rounded corner frame shape. The protrusion portion 242 is formed in a rectangular shape. The size of the protrusion portions 242 is determined by the size of a region on which the sealant 240 is coated and is a few hundred micrometers.

The sealant 240 is selected from a thermosetting resin, an ultraviolet ray setting resin, and a thermoplastic resin. The thermosetting sealant can include resins of phenols, epoxies, polyurethanes, and polyesters.

The frame portion 241 of the sealant 240 has a frame shape surrounding the image display unit 230 along the edges of the substrate 210 or the sealing member 220.

Also, the protrusion portion 242 has a pattern having a block shape protruding from one corner of the frame portion 241.

The organic light emitting display device has a cross-sectional structure as depicted in FIG. 2.

Also, a sealant pattern is proposed in the organic light emitting display device for sealing the substrate, on which light emitting diodes such as the OLEDs are arranged, using a sealing member.

In the present invention, the bonding force between the upper and lower substrates is increased by including protrusion portions of the sealant at the corners of the substrate. That is, the protrusion portions can be included at the sides of the substrate.

As described above, the organic light emitting display device according to the present invention increases the bonding force between the substrate and the sealing member by including protrusion portions of the sealant at the corners of the substrate and prevents the separation of the substrate at the corners. Accordingly, the reliability and lifespan of the organic light emitting display device can be improved since defects, such as dark points, due to the penetration of oxygen or moisture, can be prevented.

Also, when applied to a flexible organic light emitting display device, the organic light emitting diode can be protected from separation of panel edges due to bending of the substrate, and can provide a sufficient bonding force between the upper and lower substrates of a large display.

## Claims

1. A flat display device, comprising:
a substrate (110) having a rectangular shape and including an image display unit (130) on which display devices are arranged, wherein organic light emitting diodes (160) are arranged in the image display unit (130) of the substrate (110) and the organic light emitting diodes (160) include a lower electrode (161), an organic thin film layer (163), and an upper electrode (165);
a sealing member (120), wherein the sealing member (120) is adapted to seal the substrate (110) with a sealant (140), the sealant (140) including a frame portion (141) consisting of four frame members (141) arranged such to form an rectangle which surrounds the image display unit (130), and
the sealant (140) consists of one material which is selected from the group consisting of a thermosetting resin, an ultraviolet setting resin, and a thermoplastic resin,
wherein the sealant (140) comprises protrusion portions (142) at each corner of the four frame members (141);
**characterized in that**
the said four protrusion portions (142) are adapted for preventing the separation of the substrate (110) at corners of the substrate (110), and
wherein each protrusion portion (142) consists of a block pattern shaped part each protruding from the frame portion (141) toward an adjacent corner of the substrate (110), the block pattern shaped part consisting of a rectangular shape.

2. The flat display device of claim 1, wherein the frame portion (141) of the sealant (140) comprises angled or rounded corners.

3. The flat display device of claim 1, further comprising a flexible display device including a flexible substrate as the substrate (110) and the sealing member (120).

## Patentansprüche

1. Eine flache Anzeigevorrichtung, umfassend:
ein Substrat (110) mit einer rechteckigen Form und mit einer Bildanzeigeeinheit (130), auf der Anzeigevorrichtungen angeordnet sind, wobei organische Leuchtdioden (160) in der Bildanzeigeeinheit (130) des Substrats (110) angeordnet sind und die organischen Leuchtdioden (160) eine untere Elektrode (161), eine organische Dünnfilmschicht (163) sowie eine obere Elektrode (165) aufweisen;
ein Abdichtelement (120), wobei das Abdichtelement (120) dazu ausgelegt ist, das Substrat (110) mit einem Abdichtmittel (140) abzudichten, wobei das Abdichtmittel (140) einen Rahmenteil (141) aufweist, der aus vier Rahmenelementen (141) besteht, die derart angeordnet sind, dass sie ein Rechteck bilden, das die Bildanzeigeeinheit (130) umgibt, und
das Abdichtmittel (140) besteht aus einem Material, das aus der aus einem wärmehärtenden Harz, einem ultravioletthärtenden Harz und einem thermoplastischen Harz bestehenden Gruppe ausgewählt ist,
wobei das Abdichtmittel (140) Vorsprungsteile (142) aufweist, die an jeder Ecke der vier Rahmenelemente (141) angeordnet sind,
**dadurch gekennzeichnet, dass**
die genannten vier Vorsprungsteile (142) dazu ausgelegt sind, die Abtrennung des Substrats (110) an Ecken des Substrats (110) zu verhindern,
wobei jeder Vorsprungsteil (142) aus einem blockmusterförmigen Teil besteht, wobei jeder blockmusterförmige Teil vom Rahmenteil (141) in Richtung einer benachbarten Ecke des Substrats (110) herausragt, und wobei der blockmusterförmige Teil aus einer rechteckigen Form besteht.

2. Die flache Anzeigevorrichtung nach Anspruch 1, wobei der Rahmenteil (141) des Abdichtmittels (140) abgewinkelte oder abgerundete Ecken umfasst.

3. Die flache Anzeigevorrichtung nach Anspruch 1, ferner umfassend eine flexible Anzeigevorrichtung, die ein flexibles Substrat als das Substrat (110) und das Abdichtelement (120) beinhaltet.

## Revendications

1. Dispositif d'affichage plat, comprenant :
un substrat (110) ayant une forme rectangulaire et incluant une unité (130) d'affichage d'image sur laquelle sont agencés des dispositifs d'affichage, dans lequel des diodes organiques (160) émettrices de lumière sont agencées dans l'unité (130) d'affichage d'image du substrat (110) et dans lequel les diodes organiques (160) émettrices de lumière incluent une électrode inférieure (161), une couche (163) de film mince organique et une électrode supérieure (165) ;
un élément (120) d'étanchéité, dans lequel l'élément (120) d'étanchéité est apte à rendre étanche le substrat (110) à l'aide d'un joint (140), le joint (140) incluant une partie cadre (141) constituée de quatre éléments (141) de cadre agencés de façon à former un rectangle qui entoure l'unité (130) d'affichage d'image, et
le joint (140) étant constitué d'une matière qui est choisie à partir du groupe consistant en une résine thermodurcissable, une résine polymérisable aux ultraviolets et une résine thermoplastique, dans lequel le joint (140) contient des parties en saillie (142) agencées à chaque coin des quatre éléments (141) du cadre,
**caractérisé en ce que** les susmentionnée quatre parties en saillie (142) sont aptes à empêcher le décollement du substrat (110) au niveau des coins du substrat (110), et
dans lequel chaque partie en saillie (142) est constituée d'une pièce conformée en un bloc, chacune faisant saillie de la partie cadre (141) en direction d'un coin adjacent du substrat (110), la pièce conformée en un bloc présentant une forme rectangulaire.

2. Dispositif d'affichage plat selon la revendication 1, dans lequel la partie cadre (141) du joint (140) comprend des coins en angle ou arrondis.

3. Dispositif d'affichage plat selon la revendication 1, comprenant en outre un dispositif d'affichage souple incluant, comme substrat (110), un substrat souple et l'élément (120) d'étanchéité.
